# EUROPEAN PATENT APPLICATION

(11) **EP 1 158 389 A2**
(43) Date of publication of application: **28.11.2001**
(21) Application number: 00126464.7
(22) Date of filing: 07.12.2000
(51) Int. Cl.: G06F 1/20

(54) **Computer having cooling apparatus and heat exchanging device of the cooling apparatus**

(30) Priority: 25.05.2000 US 579282; 30.10.2000 KR 2000640009
(71) Applicant: Cheon, Kioan, Federal Way, Washington 98023 (US)
(72) Inventor: Cheon, Kioan, Federal Way, Washington 98023 (US)
(74) Representative: Lorenz, Werner

(57) **Abstract**

A computer having a cooling apparatus and a heat exchanging device of the cooling apparatus are provided. The cooling apparatus includes a heat exchanging device for absorbing heat from heat-producing components. A passageway is provided in the heat exchanging device and a liquid coolant circulates through the passageway. A heat dissipation device has a liquid coolant reservoir having radiating fins provided on its surface. The heat exchanging device and the reservoir are connected by a first conduit and a second conduit. The liquid coolant circulates from the heat dissipation device to the heat exchanging device and back to the heat dissipation device by means of a pump. The heat dissipation device is separated from an interior space of the computer by a separating wall for isolating the heat-producing components from the flow of ambient air. The flow of ambient air passing through the radiating fins for exhausting heat from the liquid coolant can be produced by natural convection or forcibly produced by a fan.

## Description

### BACKGROUND OF THE INVENTION

### 1. Field of the Invention

The present invention relates to a computer having a cooling apparatus and a heat exchanging device of the cooling apparatus, and more particularly, to a computer having a cooling apparatus with improved cooling capacity and configured to prevent contamination due to the flow of ambient air, and a heat exchanging device for use in the cooling apparatus.

### 2. Description of the Related Art

It is well known that computers and other electronic devices commonly include components that produce heat. Various types of cooling systems have been proposed for removing heat from the heat-producing components to maintain the electronic device within operating temperature limits. Although there are various known systems including hydrocooling systems, air cooling system and systems that employ gaseous and liquid coolants, the most typically systems are forced air cooling systems having fans. However, there are many drawbacks associated with the conventional systems. One of the drawbacks is lack of cooling capacity. Recently, according to rapid development of electronic devices, components of the electronic devices have become highly integrated and heat-producing densities are also increasing. Accordingly, the presently typically used air cooling systems have limitations in solving the problem of heat production in spite of continued improvement of cooling fan performance. Also, efforts to increase cooling capacity result in bulkiness and complexity of cooling systems.

Another drawback of the conventional air cooling systems include noise due to use of fans. As the modern society became advanced, the working conditions of people are inseparable from computers or various electronic devices and people are getting highly sensitive to ambient noise. Therefore, quiet working conditions are essentially important to people who concentrate on various kinds of business in a closed working space.

A third problem with the conventional cooling systems is contamination of computers due to fans for creating air stream for cooling components of heat-producing components of computers or other elements of cooling systems such as radiators. Due to fans used for dissipating internally produced heat to the outside of the computers, dust or contaminants are induced into the computers together with the external air. The induced dust or contaminants contaminate the electronic devices to cause damages and are stacked inside the computers, thereby obstructing the flow of air, which lowers the cooling efficiency. However, high-priced industrial computers are inevitably exposed to inferior circumstances to be cooled, resulting various kinds of contamination. Thus, the life spans of expensive computers may be shortened or the defects thereof may increase.

### SUMMARY OF THE INVENTION

To solve the above problems, it is an objective of the present invention to provide a computer having a cooling apparatus with improved cooling capacity and configured such that a fan and radiating fins are isolated from heat-producing components for preventing contamination due to the flow of ambient air.

It is another objective of the present invention to provide a heat exchanging device for use in the cooling apparatus, for cooling various kinds of heat-producing components of a computer.

The present invention provides a computer having a housing defining an interior space and at least one heat-producing component installed inside the housing, including a heat exchanging device in heat exchangeably contact with the heat-producing component and having a passageway extending between an inlet port and an outlet port, a heat dissipation device having a reservoir for storing a liquid coolant having an inlet opening and an outlet opening spaced a predetermined distance apart from the inlet opening, and a plurality of radiating fins installed on the outer surface of the reservoir so as to be capable of exchanging heat with the reservoir, a first conduit extending between the outlet port of the heat exchanging device and the inlet opening of the reservoir, a second conduit extending between the outlet opening of the reservoir and the inlet port of the heat exchanging device, a pump for pumping the liquid coolant out of the reservoir through the outlet opening, through the second conduit, the passageway and the first conduit, and back into the reservoir through the inlet opening, and a separating wall separating the heat dissipation device from the interior space to isolate the heat-producing component from the flow of ambient air.

The cooling apparatus incorporated in the computer according to the present invention can be used with various types of computers. A first embodiment of the present invention is designed for use with a personal computer having a tower case. The heat dissipation device is mounted in a subhousing installed on a bottom of the tower case. Alternatively, the separating wall may be installed inside the tower case. In this case, the heat dissipation device is installed between the separating wall and the bottom wall or the side wall of the tower case.

A second embodiment of the invention is designed for use in industrial computers each having a housing in the form of a rack mount case. The case has inlet vents extending through a side wall thereof, and outlet vents extending through a side wall thereof, spaced from the inlet vents. The heat dissipation device has opposite ends positioned adjacent to the inlet vents and the outlet vents, respectively. Positioning the vents through side walls avoids any problem of air flow being blocked by vertically adjacent devices on a multi-layered rack.

Also, the computer may further include a fan disposed adjacent to one end of the heat dissipation device and in communication with ambient air, for compelling the ambient air to flow through the radiating fins to exhaust the heat from the liquid coolant stored in the reservoir, the fan being isolated from the interior space by the separating wall.

The invention also provides a heat exchanging device for cooling heat-producing components of a computer. The heat-producing components of a computer have a variety of types and configurations, and the heat exchanging device also has various types and configurations. In other words, the heat exchanging devices designed for cooling a power supply, a hard drive, a CPU and a memory of a computer have adaptive configurations and types, respectively.

The invention provides a cooling apparatus and a computer having the same that avoid the drawbacks of the conventional cooling systems discussed above and at the same time achieve efficient, effective, reliable cooling of heat-producing components. According to the present invention, heat-producing components can be efficiently cooled by a hydro-cooling system using a liquid coolant while protecting the heat-producing components from contamination due to contact with flow of ambient air.

The flow of ambient air passing through the radiating fins for exhausting heat from the liquid coolant can be produced by natural convection or forcibly produced by a fan. The fan provided in the cooling apparatus can be adjusted to operate at rated power or at a level lower than the rated power, and is designed to have sufficient cooling capacity even when it operates at a level lower than the rated power. If the fan is operated at a level lower than the rated power, e.g., at a level 70% of the rated power, only a very small amount of noise is generated, compared to the case where the fan is operated at full power. Such extent of noise is barely perceptible under ordinary working circumstances, allowing agreeable working conditions. Also, if the fan is operated at a level of 70% of full power, the life span of the fan can be greatly increased, thereby increasing the replacement cycle, and unpleasant noise is reduced. In summers in which the atmospheric temperature is high or under inferior circumstances, the fan can be operated at full power to maximize the cooling capacity. In this case, a temperature sensor may be provided. The temperature sensor allows automatic adjustment of the speed of the fan according to the temperature of a heat-producing component.

The apparatus of the invention is relatively simple in construction and readily adaptable to various types of computers.

### BRIEF DESCRIPTION OF THE DRAWINGS

The above objectives and advantages of the present invention will become more apparent by describing in detail a preferred embodiment thereof with reference to the attached drawings in which:
FIGS. 1A and 1B are perspective views illustrating the outer appearance of a personal computer having a cooling apparatus according to a preferred embodiment of the present invention, when viewed from the front and rear thereof, respectively;
FIG. 2 is a schematic diagram illustrating the structure of the cooling apparatus incorporated in the personal computer shown in FIG. 1A or 1B;
FIGS. 3A through 3C are partly cut-away perspective views a personal computer having a heat dissipation device provided inside a tower case, when viewed from the front thereof, unlike in FIGS. 1A and 1B;
FIG. 4A is a perspective view illustrating the outer appearance of the heat dissipation device shown in FIG. 2, FIG. 4B is a cross-sectional view of the heat dissipation device shown in FIG. 4A, taken along the line A-A, and FIG. 4C is a cross-sectional view of the heat dissipation device shown in FIG. 4A, taken along the line B-B;
FIGS. 5A and 5B are a partly cut-away perspective view and an elevational view of a heat exchanging device according to an embodiment of the present invention for use in a power supply, respectively;
FIG. 6 is a partially exploded perspective view of a heat exchanging device according to another embodiment of the present invention for use in a power supply;
FIG. 7A is a partly cross-sectioned elevational view of a heat exchanging device according to another embodiment of the present invention for use in a power supply, and FIG. 7B is a partly cut-away perspective view of a heat exchanging device according to still another embodiment of the present invention for use in a power supply;
FIG. 8 is an exploded perspective view of a heat exchanging device according to a preferred embodiment of the present invention for use in a hard drive; FIG. 9 is an exploded perspective view of a heat exchanging device according to another embodiment of the present invention for use in a hard drive; FIG. 10 is a perspective view illustrating the installation of the heat exchanging device shown in FIG. 9;
FIG. 11 is an exploded perspective view of a heat exchanging device according to a preferred embodiment of the present invention for use in a CPU;
FIG. 12 is a partly cross-sectioned elevational view of the heat exchanging device shown in FIG. 11;
FIG. 13 is an exploded perspective view of a preferred means for securely contacting the heat exchanging device shown in FIG. 11 with a CPU;
FIGS. 14A and 14B are a perspective view and a partly cross-sectioned elevational view illustrating the connected state of the securely contacting means shown in FIG. 13;
FIG. 15 is an exploded perspective view of another means for securely contacting the heat exchanging device shown in FIG. 11 with a CPU;
FIGS. 16A and 16B are a perspective view and a partly cross-sectioned elevational view illustrating the connected state of the securely contacting means shown in FIG. 15;
FIG. 17 is an exploded perspective view of a heat exchanging device according to a preferred embodiment of the present invention for use in a memory;
FIG. 18 is a side view showing the state in which the heat exchanging device shown in FIG. 17 is installed in the memory;
FIG. 19 is a perspective view of an industrial computer having a cooling apparatus according to anther embodiment of the present invention; and
FIG. 20 is a perspective view of an industrial computer having a cooling apparatus installed in a direction different from that in FIG. 19.

### DESCRIPTION OF THE PREFERRED EMBODIMENTS

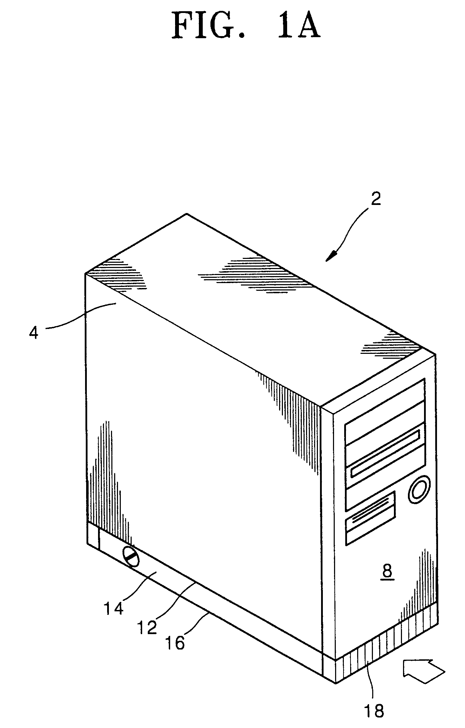

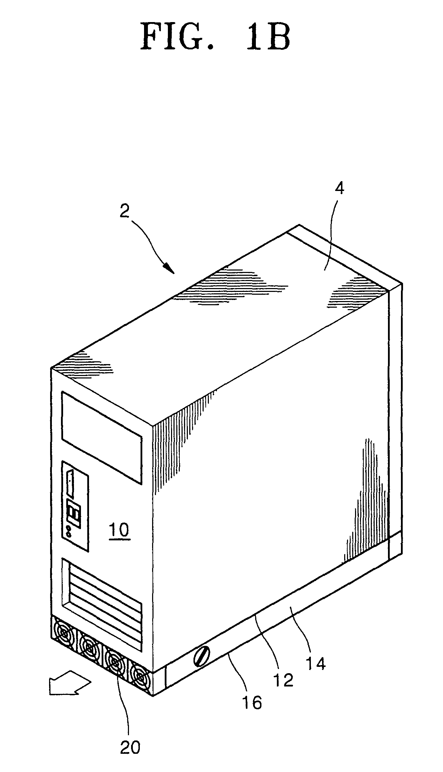

Referring to FIGS. 1A and 1B, a personal computer 2 has a housing in the form of a tower case 4. The tower case 4 has a front 8, an opposite back 10 and a lower bottom wall 12. A subhousing 14 is mounted on the bottom wall 12 of the tower case 4. The subhousing 14 itself has a bottom wall 16. Air inlet vents 18 are formed on the front end of the subhousing 14, and air outlet vents 20 are formed on the opposite rear end. Arrows shown in FIGS. 1A and 1B indicate the directions of the flow of air.

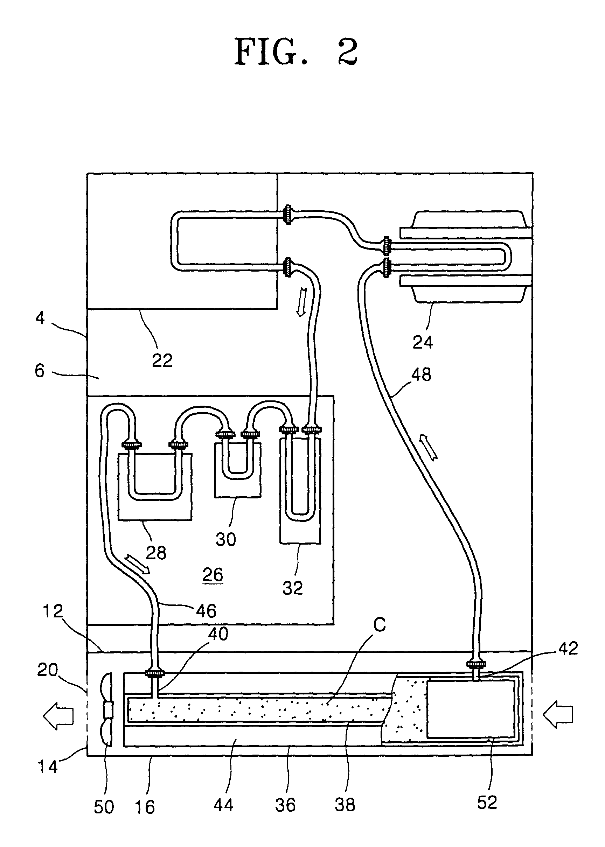

Referring to FIG. 2, the tower case 4 defines an interior space 6 of the personal computer 2. A number of components are mounted in the space 6, that is, inside the tower case 4. These components are of various types and include a number of heat-producing components. The components mounted inside the case 4 include a power supply 22 and a hard drive 24. A mother board 26 is also mounted inside the case 4. A mother board commonly has a number of components mounted thereon. In FIG. 2, three components are mounted on the mother board 26. These components are CPU 28, a microprocessor chip 30 and a memory 32. Each of these three components 28, 30 and 32, the power supply 22 and the hard drive 24 are heat-producing components. Therefore, they are provided with cooling apparatus for cooling them, as to be described below.

In accordance with the present invention, each of the heat-producing components is provided with a heat exchanging device having an internal passageway extending between an inlet port and an outlet port. The passageway is in heat exchangeably contact with the heat-producing components. Liquid coolant C circulates through the passageway to carry heat away from the components.

The cooling apparatus of the invention also includes a heat dissipation device 36. The heat dissipation device 36 is mounted in the subhousing 14 and has a reservoir 38 for storing the liquid coolant C. The reservoir 38 is preferably made from a heat conductive material, for example, aluminum. The reservoir 38 has an inlet opening 40 and an outlet opening 42 spaced from the inlet opening 40. A plurality of radiating fins 44 are mounted on the outer surface of the reservoir 38. The radiating fins 44 are in heat exchangeably contact with the outer surface of the reservoir 38. The radiating fins 44 can be integrally formed with or separately formed from the reservoir 38. The liquid coolant C is circulated from the reservoir 38 to the heat exchanging device on the heat-producing components and back to the reservoir 38. A first conduit 46 extends from the outlet port of the heat exchanging device to the inlet opening 40 of the reservoir 38. A second conduit 48 extends from the outlet opening 42 and the inlet port of the heat exchanging device. As shown, the liquid coolant C circulates through the passageways of the various heat exchanging devices for the heat-producing components in series. The liquid coolant C moves from the reservoir 38 to the inside of the heat exchanging device for the hard drive 24 through the second conduit 48 and then moves from the heat exchanging device for the hard drive 24 to the heat exchanging device for the power supply 22. From the power supply 22, the coolant C circulates consecutively through the heat exchanging devices for the memory 32, the microprocessor chip 30 and the CPU 28. From the outlet port of the heat exchanging device for the CPU 28, the coolant C circulates back via the first conduit 46 to the reservoir 38 through the inlet opening 40. Small arrows shown in FIG. 2 indicate circulation paths of the coolant C. Although the circulation paths of the coolant C are disposed in series in FIG. 2, they may be disposed in parallel or in combination of parallel and series arrangements according to the heat transfer amount of the heat-producing components and installation locations thereof. A pump 52 for circulating the coolant C is installed inside the reservoir 38, as described above.

The important feature of the present invention lies in that the heat-producing components installed in the space 6 are isolated from the flow of ambient air. To provide such isolation, one or more separating walls for separating the heat dissipation device 36 from the interior space 6 are provided. In the embodiment shown in FIGS. 1A and 1B and FIG. 2, the bottom wall 12 of the tower case 4 functions as the separating wall.

The cooling apparatus may further include a fan 50 installed in the subhousing 14. The fan 50 is positioned adjacent to an end of the heat dissipation device 36 and is in communication with ambient air through the air outlet vent 20 of the subhousing 14. The fan 50 operates to direct ambient air through the radiating fins 44 to dissipate heat from the liquid coolant C in the reservoir 38. The fan 50 is also separated from the interior space 6 by the separating wall. Large arrows shown in FIG. 2 indicate the directions of the flow of ambient air.

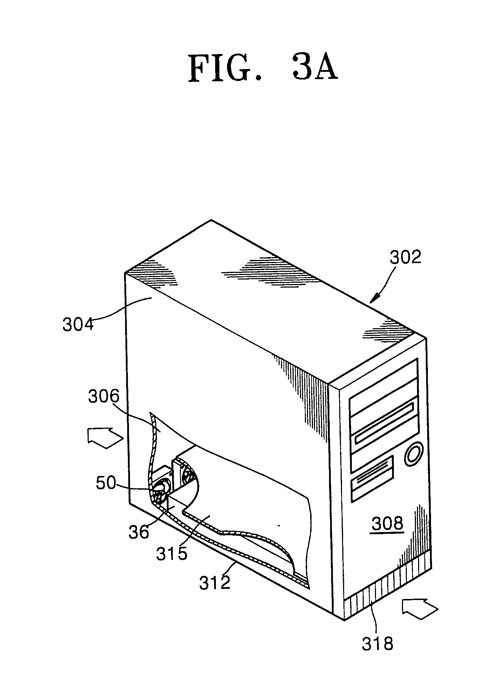

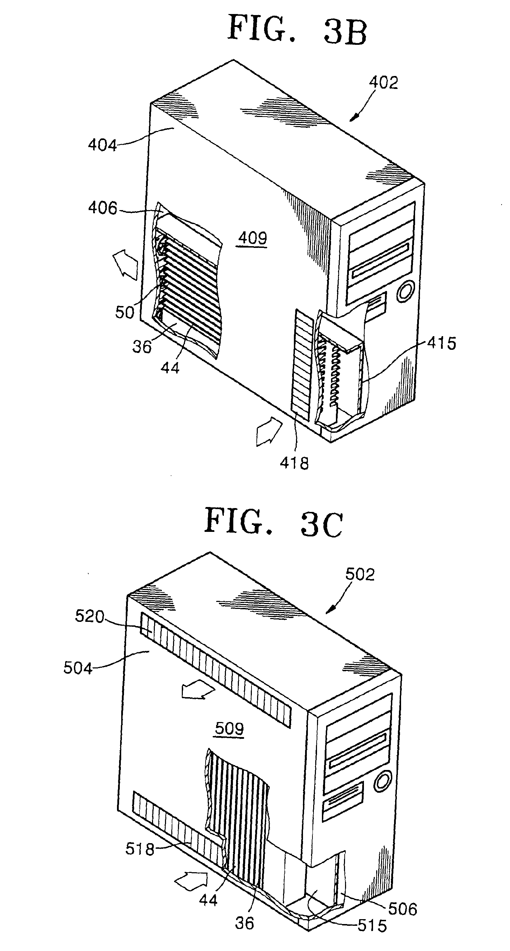

FIGS. 3A through 3C show a personal computer having a heat dissipation device provided inside a tower case, unlike in FIGS. 1A and 1B. FIG. 3A illustrates an embodiment in which a heat dissipation device is installed adjacent to the bottom wall of a tower case, and FIGS. 3B and 3C illustrate embodiments in which heat dissipation devices are installed on the side walls of a tower case. Arrows shown in FIGS. 3A through 3C indicate the directions of the flow of ambient air.

Referring to FIG. 3A, a separating wall 315 is installed inside a tower case 304 of a personal computer 302 to be spaced apart from a bottom wall 312 of the tower case 304. The heat dissipation device 36 is installed between the bottom wall 312 and the separating wall 315. Also, the fan 50 may be installed adjacent to one end of the heat dissipation device 36. An inlet vent 318 is provided adjacent to the other end of the dissipation device 36 in the lower portion of a front 308 of the tower case 304. Also, an outlet vent (not shown) is provided adjacent to the fan 50 in the lower portion of the rear of the tower case 304. In other words, the separating wall 315 is installed between the heat-producing components installed inside the interior space 306 and the heat dissipation device 36. Thus, the heat-producing components can be isolated from the flow of ambient air by the separating wall 315.

Referring to FIG. 3B, a separating wall 415 is installed inside a tower case 404 of a personal computer 402 to be spaced apart from a side wall 409 of the tower case 404. The heat dissipation device 36 is installed between the side wall 409 and the separating wall 415. Also, the fan 50 may be installed adjacent to one end of the heat dissipation device 36. An inlet vent 418 is provided adjacent to the other end of the heat dissipation device 36 on the side wall 409 of the tower case 304. Also, an outlet vent (not shown) is provided adjacent to the fan 50 in the back of the tower case 304. The radiating fins 44 of the heat dissipation device 36 are preferably horizontally installed along the direction of the flow of ambient air. Thus, the heat-producing components installed in the interior space 406 can be isolated from the heat dissipation device 36 and the fan 50 by the separating wall 415.

Referring to FIG. 3C, a separating wall 515 is installed inside a tower case 504 of a personal computer 502 to be spaced apart from a side wall 509 of the tower case 504. The heat dissipation device 36 is installed between the side wall 509 and the separating wall 515. An inlet vent 518 is provided adjacent to one end of the heat dissipation device 36 in the lower portion of the side wall 509. Also, an outlet vent 520 is provided adjacent to the other end of the dissipation device 36 in the upper portion of the side wall 509. The radiating fins 44 of the heating dissipation device 36 are preferably vertically installed along the direction of the flow of ambient air. Thus, the heat-producing components installed in the interior space 506 of the tower case 504 can be isolated from the flow of ambient air by the separating wall 515. In this embodiment, a fan is not installed, unlike the above-described embodiments. Thus, the flow of ambient air passing through the heat transfer fin s 44 is produced by natural convection. To this end, as described above, the inlet vent 518 and the outlet vent 520 are disposed in the lower and upper portions of the side wall 509, respectively. The air induced through the inlet vent 518 provided in the lower portion of the side wall 509 becomes warmer while passing through the radiating fins 44, the warm air is elevated to then be exhausted to the outside through the outlet vent 520 provided in the upper portion of the side wall 509. If the flow of ambient air is produced by natural convection rather than a fan, as described above, noise due to the use of the fan is not generated.

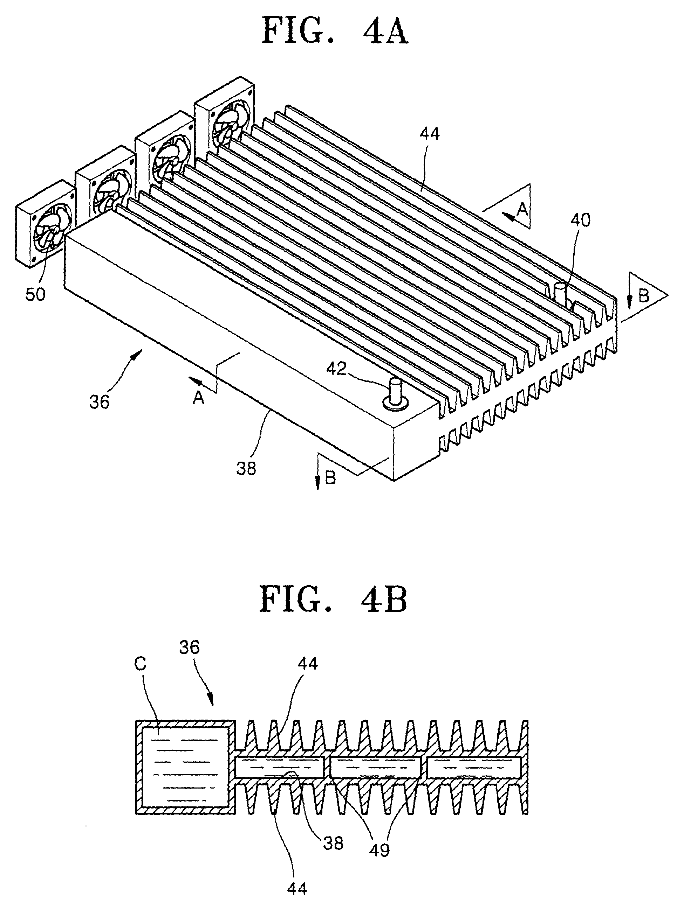

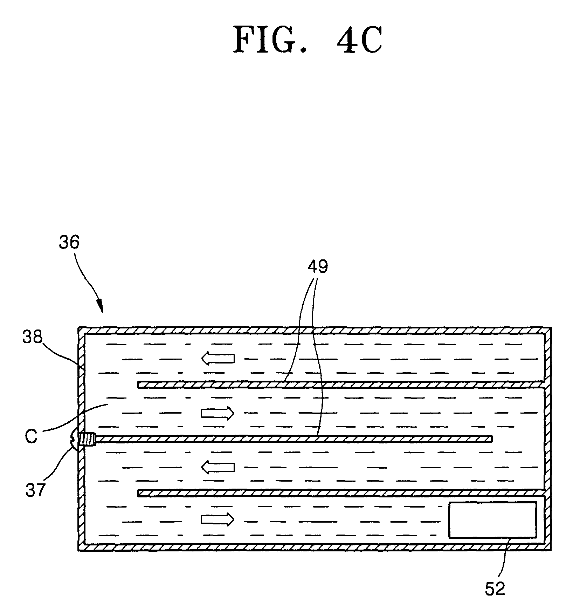

The heat dissipation device 36 will now be described in more detail with reference to FIGS. 4A, 4B and 4C. Referring thereto, the heat dissipation device 36 has the reservoir 38 for storing the liquid coolant C. The radiating fins 44 are installed on the outer surface of the reservoir 38. The fan 50 is disposed adjacent to one end of the heat dissipation device 36, and a pump 52 for circulating the liquid coolant C is installed inside the reservoir 38. An outlet opening 42 and an inlet opening 40 for exhausting and recovering the liquid coolant C, are provided on the top portion of the reservoir 38. Also, an opening for refilling/exhausting the liquid coolant C into/from the reservoir 38, is provided at one side of the reservoir 38, and a thread 37 is tightened with the opening.

One or more divider walls 49 are installed inside the reservoir 38. A selected divider wall 49 extends from one-end inner wall of the reservoir 38 and the end thereof is spaced from the other-end inner wall of the reservoir 38. The direction of the flow of the liquid coolant C is inverted through the space between the end of the selected divider wall 49 and the other-end inner wall of the reservoir 38. Another divider wall adjacent to the selected divider wall 49 extends from the other-end inner wall of the reservoir 38. As described above, the divider wall 49 elongates the path of the flow of the liquid coolant C back into the reservoir 38 so that heat transfer from the liquid coolant C is sufficiently performed through the radiating fins 44. Arrows shown in FIG. 4C indicate the direction of the flow of the liquid coolant C.

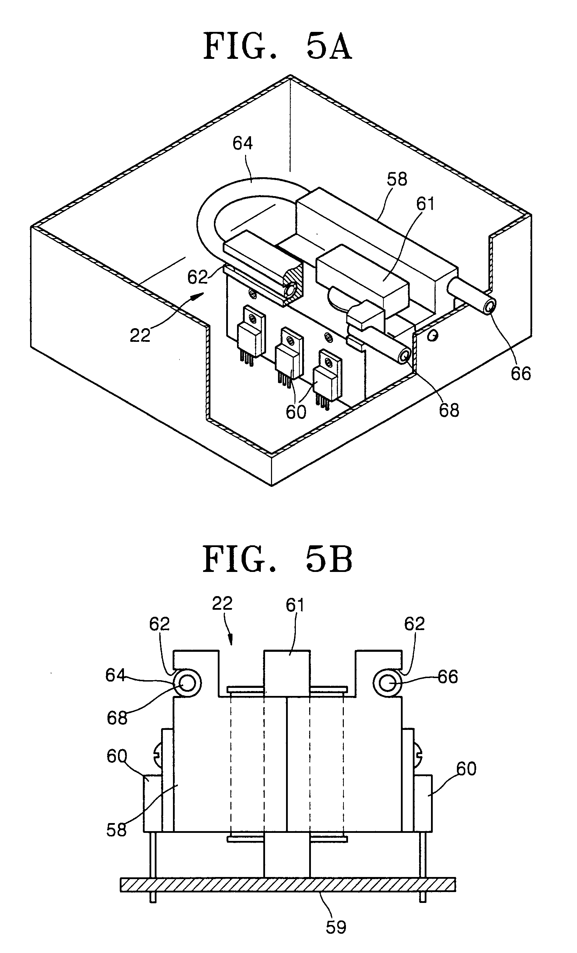

FIG. 5A and 5B illustrate preferred embodiments of heat exchanging devices for use in a power supply. Referring to FIGS. 5A and 5B, a heat exchanging device according to this embodiment includes a heat sink 58 made of aluminum. The heat sink 58 may be integrally formed by a die-casting method. The heat sink 58 is mounted on a board 59. The power supply 22 includes a plurality of heat-producing elements 60 and 61. These elements 60 and 61 are, for example, a transistor and/or a transformer. The elements 60 and 61 are mounted on the heat sink 58 and are in heat exchangeably contact with the heat sink 58. A channel 62 is provided at each side of the heat sink 58. The pair of channels 62 are parallel to each other. A U-shaped conduit 64 is fitted into the channel 62 and is in heat exchangeably contact with the heat sink 58. To this end, a heat bond is preferably interposed between the inner surface of the channel 62 and the outer surface of the U-shaped conduit 64. The opposite ends of the U-shaped conduit 64 form an inlet port 66 and an outlet port 68 of the heat exchanging device. The U-shaped conduit 64 functions as a circulation passageway of the liquid coolant of the heat exchanging device according to this embodiment. The liquid coolant circulating through the passageway carries away heat from the heat sink 58 to then be exhausted. Thus, the heat generated from the elements 60 and 61 is exhausted.

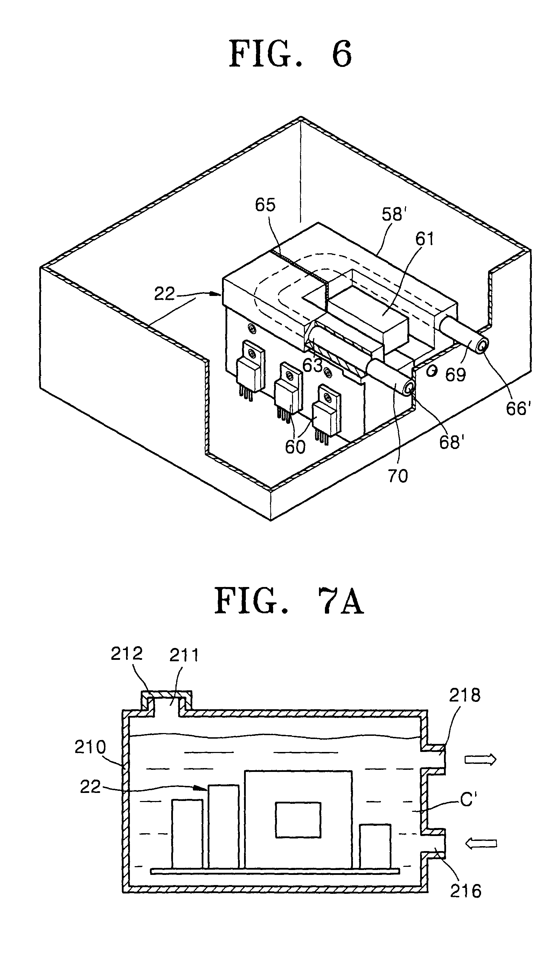

FIG. 6 illustrates another embodiment of a heat exchanging device for use in a power supply. Referring to FIG. 6, the heat exchanging device according to this embodiment includes a heat sink 58' made of aluminum. The heat sink 58' is divided into two parts. A heat pad 65 for preventing leakage and transferring heat, is inserted between the two parts and assembled. The power supply 22 includes a plurality of heat-producing elements 60 and 61. The elements 60 and 61 are mounted on the heat sink 58'. Of the elements 60 and 61, the element 61 installed in the middle of the heat sink 58', for example, a transformer, is in heat exchangeably contact with the heat sink 58' by a silicon heat bond material. Also, the element 60 installed at the lateral side of the heat sink 58', for example, a transistor, is in heat exchangeably contact with the heat sink 58'. An interior passageway 63 through which the liquid coolant passes, is formed inside the heat sink 58'. Short conduits 69 and 70 are fitted into the opposite ends of the interior passageway 63 to form an inlet port 66' and an outlet port 68' through which the liquid coolant comes in and goes out, respectively. The interior passageway 63 functions as the liquid coolant circulating passageway of the heat exchanging device according to this embodiment. The heat generated from the elements 60 and 61 is collected at the heat sink 58' and is transferred to the liquid coolant circulating through the interior passageway 63 to then be exhausted outside the heat dissipation device.

As described above, the heat exchanging devices shown in FIGS. 5A and 5B and FIG. 6 adopt a cooling method in which the heat generated from the heat-producing elements 60 and 61 of the power supply 22 is collected at aluminum heat sinks 58 and 58' to then be exhausted, that is, cooled at a time, rather than cooled separately, thereby improving the cooling capacity and simplifying the configuration.

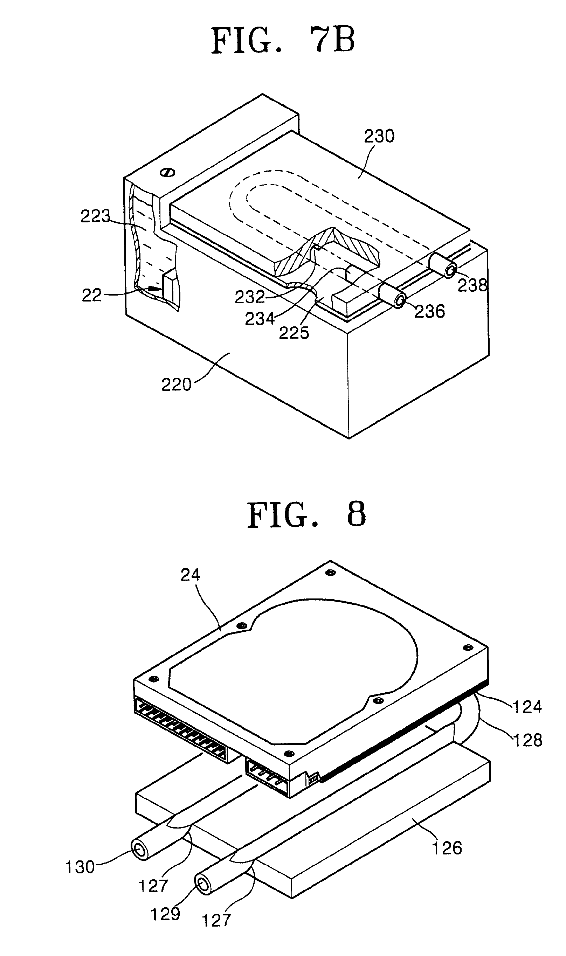

FIG. 7 shows still another embodiment of a heat exchanging device for use in a power supply. Referring to FIG. 7A, the heat exchanging device according to this embodiment includes a hermetic container 210 installed to surround the power supply 22. A liquid coolant C' contained in the hermetic container 210. The liquid coolant C' is in direct contact with the power supply 22 so as to be capable of exchanging heat. Thus, in this embodiment, an insulating oil is used as the liquid coolant C' circulating between the heat dissipation device and the heat exchanging device for insulation between the liquid coolant C' and the power supply 22. A coolant refilling opening 211 and a cap 212, for refilling the liquid coolant C', that is, the insulating oil, are provided on the top portion of the hermetic container 210. An inlet port 216 and an outlet port 218 through which the liquid coolant C' comes in and goes out, are formed on the side wall of the hermetic container 210. Preferably, the inlet port 216 is formed at the lower portion of the side wall and the outlet port 218 is formed at the upper portion of the side wall. Thus, the liquid coolant C' which comes into the hermetic container 210 through the inlet port 216 gets warmer while contacting the power supply 22, and the warmed liquid coolant C' is elevated to then be exhausted through the outlet port 218. The circulation of the liquid coolant C' is more smoothly performed by thermal convection of the liquid coolant C'. Also, the inlet port 216 and the outlet port 218 may be disposed at opposite side walls of the hermetic container 210. As described above, according to this embodiment, the insulating oil is used as the liquid coolant C', which is in direct contact with the power supply 22, thereby insulating the power supply 22 and ensuring a cooling effect.

FIG. 7B shows still another embodiment of a heat exchanging device for use in a power supply. Referring to FIG. 7B, the heat exchanging device according to this embodiment includes a hermetic container 220 installed to surround the power supply 22, like in the embodiment shown in FIG. 7A. An insulating oil 223 is contained inside the hermetic container 220 as high as it contacts an upper wall of the hermetic container 220. The insulating oil 223 is in direct contact with the power supply 22 so as to be capable of exchanging heat. A cooling plate 230 is in heat exchangeably contact with the hermetic container 220 at its outer top surface. A silicon heat pad 225 having a high heat conductivity may be inserted between the cooling plate 230 and the outer top surface of the hermetic container 220. A long, U-shaped channel 232 is provided on the bottom surface of the cooling plate 230. A U-shaped conduit 234 is fitted into the channel 232 and is in heat exchangeably contact with the cooling plate 230. To this end, a heat bond may be interposed between the inner surface of the channel 232 and the outer surface of the U-shaped conduit 234. The bottom of the U-shaped conduit 234 is formed flatly so as to be securely in contact with the outer top surface of the hermetic container 220. The opposite ends of the U-shaped conduit 234 form an inlet port 236 and an outlet port 238 of the heat exchanging device. The U-shaped conduit 234 functions as a liquid coolant circulating passageway of the heat exchanging device according to this embodiment. As described above, the insulating oil 223 of this embodiment is not used as the liquid coolant circulating between the heat dissipation device and the heat exchanging device, unlike the embodiment shown in FIG. 7A. The insulating oil 223 of this embodiment absorbs heat generated from the power supply 22 and transfers the same to the liquid coolant flowing through the passageway formed in the cooling plate 230 securely in contact with the outer top surface of the hermetic container 220. In other words, the heat generated from the power supply 22 is absorbed by the insulating oil 223 and the warmed insulating oil 223 is elevated by thermal convection. Then, the heat is transferred to the cooling plate 230 through the upper wall of the hermetic container 220 and the heat pad 225. The thus-transferred heat is then transferred to the liquid coolant flowing through the U-shaped conduit 234 installed in the cooling plate 230, thereby cooling the power supply 22. According to this embodiment, the power supply 22 can be more effectively cooled while more securely insulating the power supply 22.

FIGS. 8 through 10 illustrate two embodiments of heat exchanging devices for use in a hard drive. Recently, hard drives have rapidly developed in their performance, and in particular, high-speed revolution thereof have noticeably progressed. Accordingly, the amount of heat produced has also increased more severely. Heat-producing portions of a hard drive are mainly rotary portions or a microprocessor portion. In particular, the rise in the temperature is the most severe at the rotary portions.

The heat exchanging device shown in FIG. 8 can be used for cooling a general hard drive 24 mounted in a computer. As shown, the heat exchanging device of this embodiment includes a cooling plate 126 in heat exchangeably contact with the bottom surface of the hard drive 24. Two parallel channels 127 are spaced apart from each other on one surface of the cooling plate 126, that is, a surface in heat exchangeably contact with the bottom surface of the hard drive 24 for heat exchange. A U-shaped conduit 128 is fitted into the channels 127 and is in heat exchangeably contact with the cooling plate 126. To this end, a heat bond may be interposed between the inner surface of the channels 127 and the outer surface of the U-shaped conduit 128. The opposite ends of the U-shaped conduit 128 form an inlet port 129 and an outlet port 130 of the heat exchanging device. The top surface of the U-shaped conduit 128 is formed flatly so as to be securely in contact with the bottom surface of the hard drive 24. The U-shaped conduit 128 functions as the liquid coolant circulating passageway of the heat exchanging device according to this embodiment. Also, a silicon heat pad 124 having a high heat conductivity may be inserted between the cooling plate 126 and the bottom surface of the hard drive 24. The heat pad 124 allows the heat produced from the hard drive 24 to be easily transferred to the cooling plate 126. Thus, the heat produced at the hard drive 24 is transferred to the cooling plate 126 through the heat pad 124 and then transferred to the liquid coolant flowing through the U-shaped conduit 128 installed in the cooling plate 126, thereby cooling the hard drive 24.

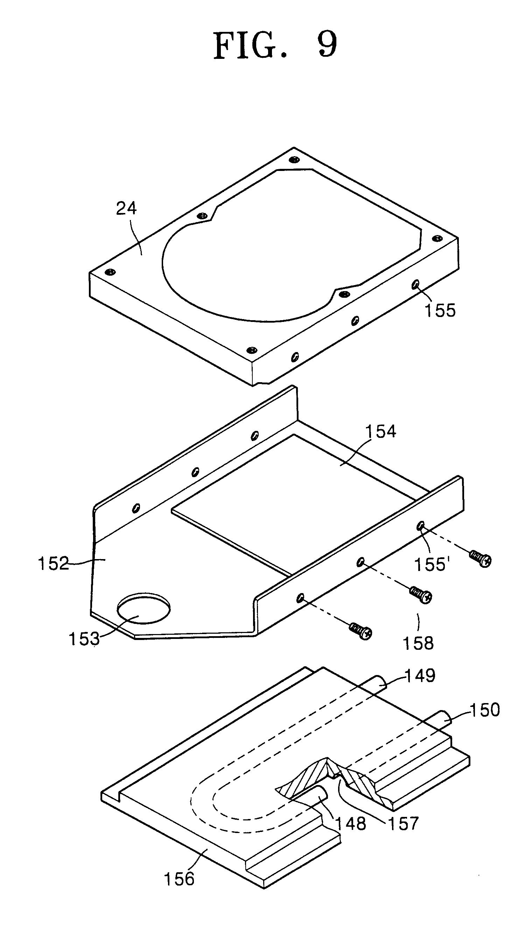

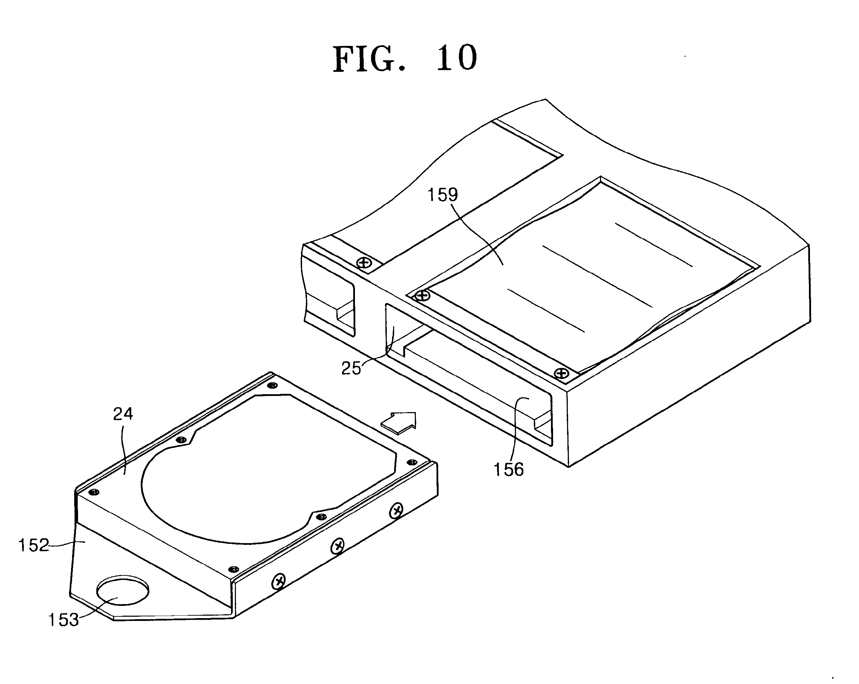

Heat exchanging devices shown in FIGS. 9 and 10 can be used for cooling the hard drive 24 capable of swapping to be installed in a computer so as to be replaceable. Referring to FIG. 9, the heat exchanging device of this embodiment includes a heat collecting plate 152 in heat exchangeably contact with the bottom surface of the hard drive 24 so as to be capable of exchange heat. The heat collecting plate 152 is preferably formed of a material having a high heat conductivity, e.g., copper. A silicon heat pad 154 having a high heat conductivity is inserted between the heat collecting plate 152 and the bottom surface of the hard drive 24 to allow the heat generated at the hard drive 24 to be easily transferred to the heat collecting plate 152. The hard drive 24 and the heat collecting plate 152 can be securely combined by thread holes 155 and 155' provided at the respective lateral surfaces and tightening threads 158 tightened with the thread holes 155 and 155'. A handle 153 for facilitating replacement of the hard drive 24 is provided at one end of the heat collecting plate 152. The heat exchanging device includes a cooling plate 156 in heat exchangeably contact with the bottom surface of the heat collecting plate 152. A long, U-shaped channel 157 is provided on the bottom surface of the cooling plate 156. A U-shaped conduit 148 is fitted into the channel 157 and is in heat exchangeably contact with the cooling plate 156. To this end, a heat bond may be interposed between the inner surface of the channel 157 and the outer surface of the U-shaped conduit 148. The opposite ends of the U-shaped conduit 148 form an inlet port 149 and an outlet port 150 of the heat exchanging device. The U-shaped conduit 148 functions as a liquid coolant circulating passageway of the heat exchanging device according to this embodiment. As described above, the heat generated from the hard drive 24 is transferred to the heat collecting plate 152 through the heat pad 154 and then transferred to the liquid coolant flowing through the U-shaped conduit 148 installed in the cooling plate 156 securely in contact with the heat collecting plate 152, thereby cooling the hard drive 24.

Referring to FIG. 10, the cooling plate 156 is installed on the interior bottom of a slot 25 for mounting the hard drive 24 provided in a computer so as to be replaceable. Thus, if the combined structure of the hard drive 24 and the heat collecting plate 152 is fitted into the slot 25, the bottom surface of the heat collecting plate 152 is brought into heat exchangeably contact with the top surface of the cooling plate 156. Here, the handle 153 provided at the heat collecting plate 152 makes the combined structure of the hard drive 24 and the heat collecting plate 152 easily detachable from the slot 25. A plate spring 159 having one end fixed is installed on the slot 25. The plate spring 159 presses the top surface of the hard drive 24 by its elasticity when the combined structure is inserted into the slot 25, thereby making the bottom surface of the heat collecting plate 152 more securely contact with the top surface of the cooling plate 156. Thus, the heat conductivity between the heat collecting plate 152 and the cooling plate 156 is increased. The plate spring 159 is bent so as to increase the contact portions with the top surface of the hard drive 24, to achieve balancing at pressure.

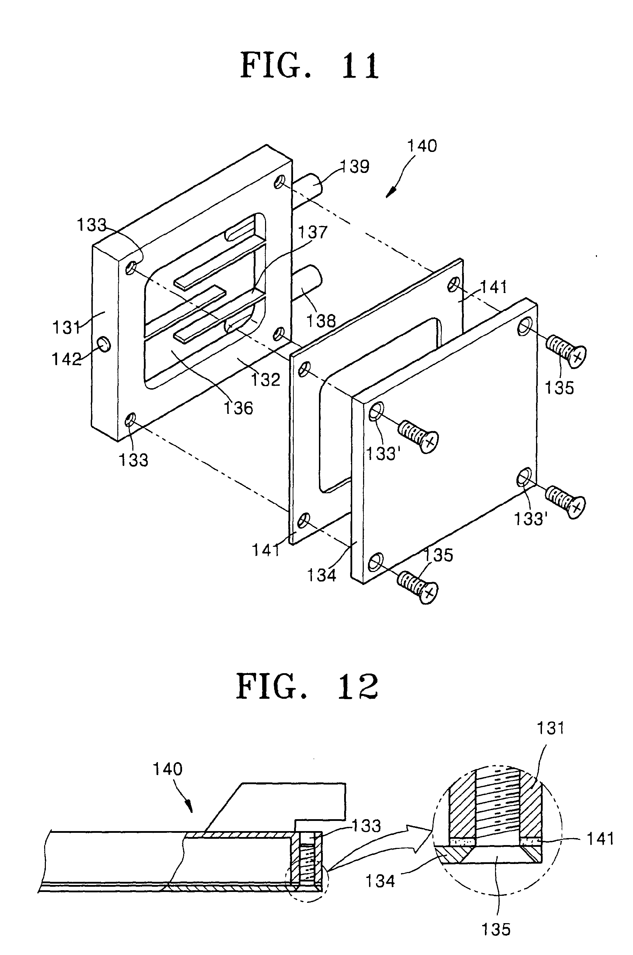

FIGS. 11 and 12 illustrate preferred embodiments of heat exchanging devices for use in a CPU. As shown, the heat exchanging device 140 includes a cooling plate 131. A passageway 136 through which a liquid coolant passes is provided on the inner surface 132 of the cooling plate 131. An inlet port 138 and an outlet port 139 through which the liquid coolant comes in and goes out, are provided at the opposite ends of the passageway 136. The passageway 136 is formed by a rectangular recess formed on the inner surface 132 and divider walls 137 installed in the interior of the rectangular recess. The divider walls 137 extend across the rectangular recess about two-thirds of the way from one recess wall to an opposite recess wall. One or more divider walls may be installed. In the case where two or more divider walls 137 are installed, a divider wall adjacent to a selected divider wall extends from the opposite recess wall in order to make the passageway serpentine. The serpentine passageway 136 allows sufficient heat transfer by making the flow path of the liquid coolant longer. A temperature sensor 142 for controlling the temperature of a CPU may be installed at one side of the cooling plate 131. The speed of the fan can be adjusted according to the temperature detected by the temperature sensor 142. Thus, when the temperature excessively rises, the system can be made to stop operating for safety and a warning message can be issued. Also, the temperature detected by the temperature sensor 142 can be displayed to be notified to a user.

The heat exchanging device 140 includes a bottom plate 134 having one surface being securely in contact with the inner surface 132 of the cooling plate 131 for hermetically sealing the liquid coolant. The bottom plate 134 is preferably formed of copper having a high heat conductivity. The other surface of the bottom plate 134 is in heat exchangeably contact with the surface of the CPU. Thread holes 133 and 133' are provided at four edges of the cooling plate 131 and the bottom plate 134, respectively, so that the cooling plate 131 and the bottom plate 134 are securely tightened with each other by tightening threads 135. Preferably, a heat pad 141 is inserted between the inner surface 132 of the cooling plate 131 and the bottom plate 134 along the periphery of the recess in order to prevent leakage and enhance the heat conductivity.

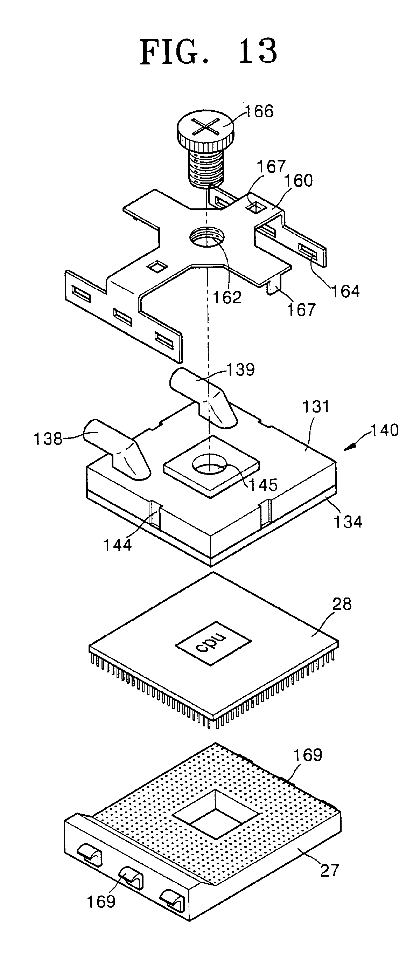

FIGS. 13 through 16B illustrate means for securely contacting heat exchanging devices according to the above-described embodiments with the surface of a CPU.

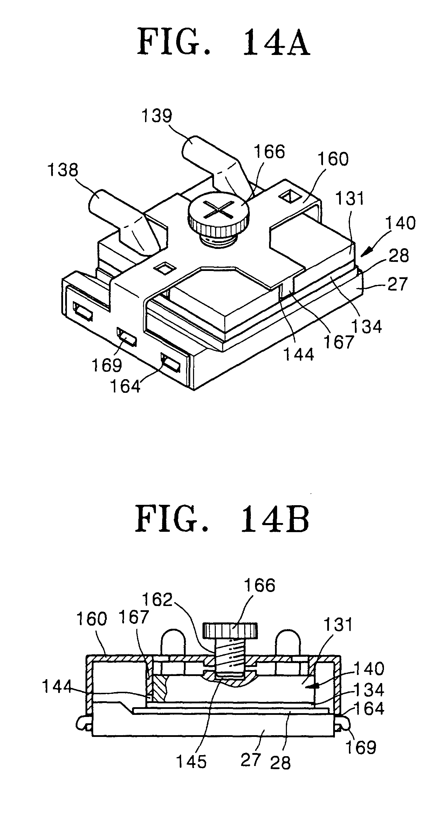

The means illustrated in FIGS. 13, 14A and 14B can be used for securely contacting the heat exchanging devices according to the above-described embodiments with a socket type CPU. As shown, projections 169 are provided on at least two facing lateral sides of a CPU socket 27 on which a CPU 28 is mounted. The securely contacting means used for the CPU 28 includes a crossed compression plate 160 installed on the cooling plate 131 and a fastening thread 166 for securely contacting the bottom plate 134 with the surface of the CPU 28 by pressing the top surface of the cooling plate 131. A thread hole 162 to which the fastening thread 166 is engaged is provided in the center of the compression plate 160. Two facing ends of the compression plate 160 are bent downward, and locking openings 164 locked with the projections 169 are formed at the bent ends. Locking openings 164, equal in number to the projections 169, here three, are preferably formed at each of the bent ends. Also, a thread center maintaining groove 145 for maintaining the center of the fastening thread 166 is provided in the center on the cooling plate 131. An inlet port 138 and an outlet port 139 of the heat exchanging device 140 protrude upward on the cooling plate 131 in order to avoid interference with the compression plate 160. In a state in which the compression plate 160 is installed on the heat exchanging device 140 and the locking opening 164 is locked with the projection 169, the fastening thread 166 is fastened, the fastening thread 166 presses the heat exchanging device 140 to then be brought securely into contact with the surface of the CPU 28. Thus, the bottom plate 134 of the heat exchanging device 140 can be more securely in contact with the surface of the CPU 28.

Rotation preventing grooves 144 and rotation preventing ribs 167 are provided for preventing the heat exchanging device 140 from rotating when the fastening thread 166 is fastened. The rotation preventing grooves 144 are vertically formed on at least one of four lateral surfaces of the cooling plate 131, preferably, one on each lateral surface of the cooling plate 131. The rotation preventing ribs 167 are provided on the compression plate 160 to be disposed at locations corresponding to the rotation preventing grooves 144. The rotation preventing ribs 167 protrude downward from the compression plate 160 so as to be fitted into the rotation preventing grooves 144 when the compression plate 160 is installed in the heat exchanging device 140.

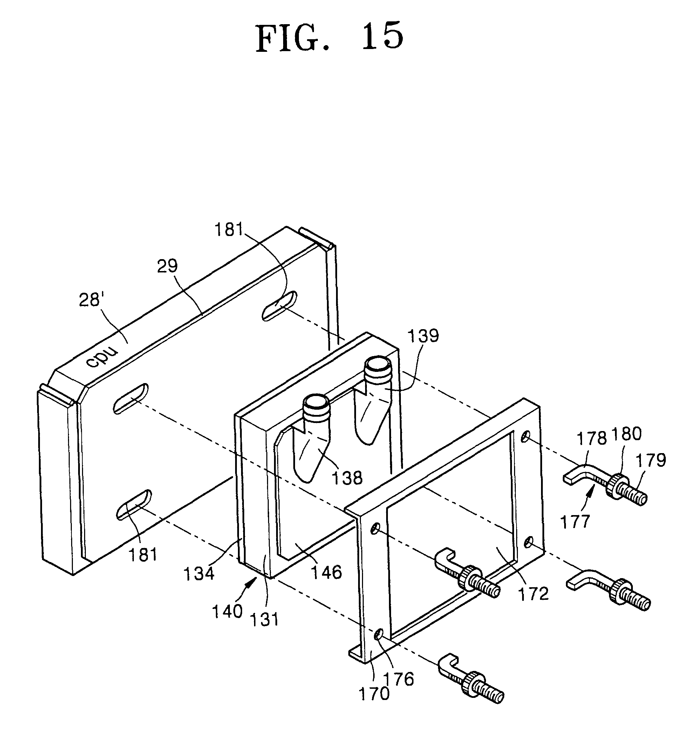

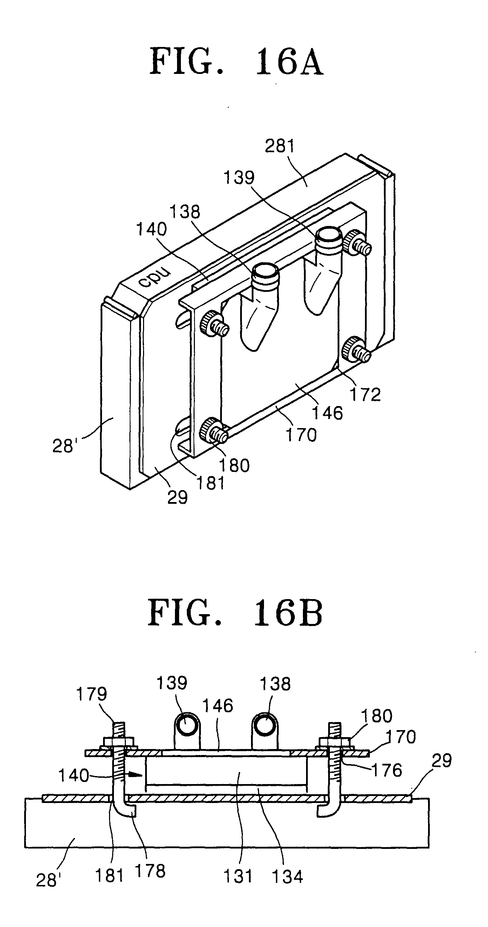

The means illustrated in FIGS. 15, 16A and 16B can be used for securely contacting the heat exchanging device shown in FIG. 11 with a slot type CPU. As shown, a slot type CPU 28' includes an outer plate 29 made of aluminum and a plurality of first throughholes 181 are formed on the outer plate 29. The securely contacting means for use in the CPU 28' includes fasteners 177 for pressing the compression plate 170 installed to be in contact with the surface of the cooling plate 131 and the heat exchanging device 140.

A rectangular opening 172 is formed in the central portion of the compression plate 170. The opening 172 allows the compression plate 170 to be installed on the heat exchanging device 140 without being interfered by the inlet port 138 and the outlet port 139. Also, a protruding surface 146 protruding a predetermined height, preferably equal to the thickness of the compression plate 170, is provided on the cooling plate 131. The shape and size of the protruding 146 are determined so as to be fitted into the opening 172 when the compression plate 170 is combined with the heat exchanging device 140. Thus, when the heat exchanging device 140 and the compression plate 170 are installed in the CPU 28', the heat exchanging device 140 is not moved separately from the compression plate 170, thereby facilitating the installation. Such configuration is advantageously used for installing the heat exchanging device 140 on the lateral side of the CPU 28' which is disposed upright.

A plurality of second throughholes 176 corresponding to the first throughholes 181 are provided at four edges of the compression plate 170. The fasteners 177 are inserted into the first throughholes 181 and also inserted into the second throughholes 176 corresponding to the first throughholes 181. One end 178 of each fastener 177 is crooked so as to be locked with the inner surface of the outer plate 29 of the CPU 28', and each tightening nut 180 is engaged with the other end 179 of the fastener 177. If the tightening nut 180 is tightened, the compression plate 170 presses the top surface of the cooling plate 131 to bring the bottom plate 134 securely into contact with the surface of the CPU 28', that is, the outer surface of the outer plate 29. Thus, the bottom plate 134 of the heat exchanging device 140 can be more securely in contact with the surface of the CPU 28'.

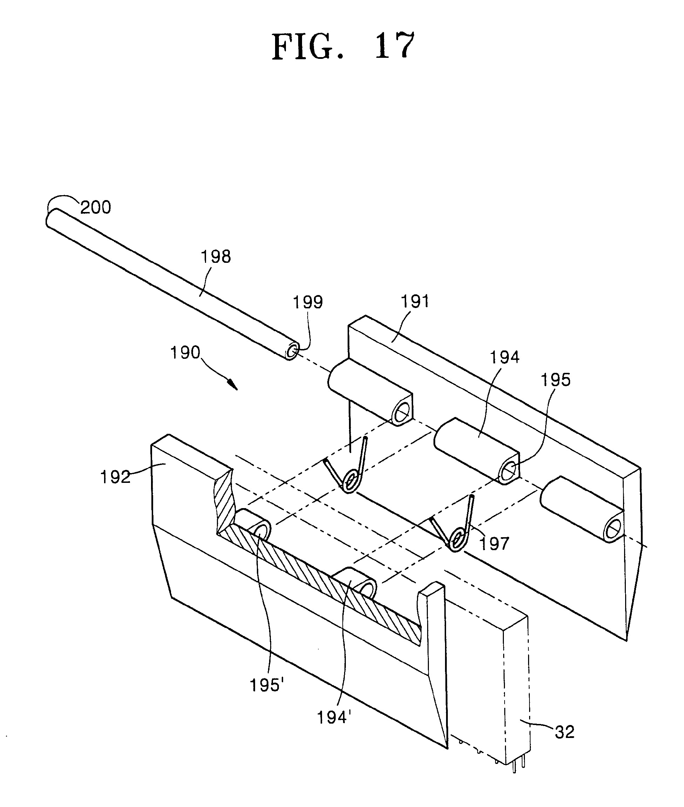

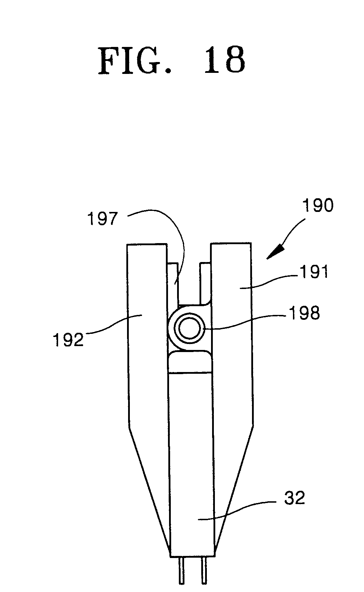

FIGS. 17 and 18 illustrate preferred embodiments of a heat exchanging device 190 for use in a memory. As shown, the heat exchanging device 190 includes a first cooling plate 191 and a second cooling plate 192 in heat exchangeably contact with both sides of a memory 32. At least two first connecting projections 194 are provided lengthwise on the inner surface of the first cooling plate 191, that is, on the surface facing the second cooling plate 192 and are spaced a predetermined distance apart from each other. The first connecting projections 194 have first conduit insertion holes 195 piercing lengthwise so that a conduit 198 having a long rod shape is inserted therethrough. Also, second connecting projections 194' inserted between the first connecting projections 194 to then be engaged, are provided on the inner surface of the second cooling plate 192, that is, on the surface facing the first cooling plate 191. The second connecting projections 194' also have second conduit insertion holes 195' piercing lengthwise so that the conduit 198 is inserted therethrough. In a state in which the first cooling plate 191 is combined with the second cooling plate 192 so that the first connecting projections 194 and the second connecting projections 194' are engaged, the conduit 198 is inserted into the first and second conduit insertion holes 195 and 195'. Here, a torsion spring 197 is fitted along the periphery of the conduit 198. The torsion spring 197 is interposed between the first cooling plate 191 and the second cooling plate 192 to apply elastic force thereto so that the inner surface of each of the first and second cooling plates 191 and 192 is brought securely into contact with both sides of the memory 32.

A heat bond is interposed between the inner surface of the first conduit insertion hole 195 piercing in the first connecting projections 194 and the outer surface of the conduit 198 so that the conduit 198 is fixed to the first cooling plate 191. However, the second cooling plate 192 can rotate freely about the conduit 198. Thus, while preventing the first and second cooling plates 191 and 192 from moving lengthwise with respect to the conduit 198, the action of the torsion spring 197 is not interfered.

The opposite ends of the conduit 198 form an inlet port 199 and an outlet port 200 through which the liquid coolant comes in and goes out. Thus, the conduit 198 functions as the liquid coolant circulating passageway of the heat exchanging device 190 according to this embodiment. The heat generated from the memory 32 is transferred to the first and second cooling plates 191 and 192 and then transferred to the liquid coolant flowing through the conduit 198, thereby cooling the memory 32. The above-described heat exchanging device 190 in which the liquid coolant circulation path is positioned at the upper portion of the memory 32, is particularly useful in the case where the distance between each of a plurality of neighboring memories 32 is small.

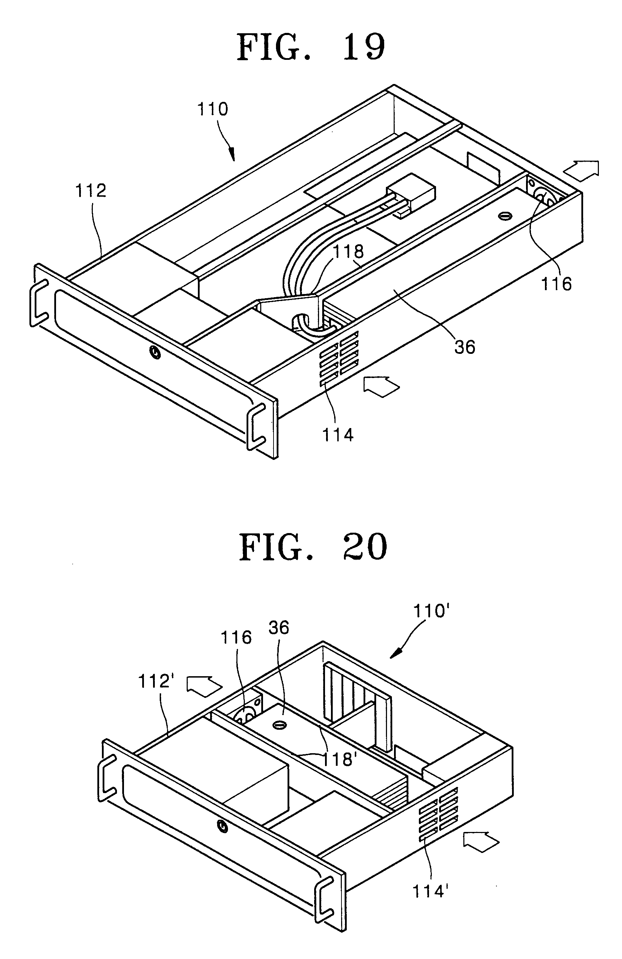

FIGS. 19 and 20 show two industrial computers 110 and 110' each having cooling apparatus according to the present invention incorporated therein. Referring to FIG. 19, the industrial computer 110 has a rack mount case 112. Inlet vents 114 are formed on one side wall of the rack mount case 112. Outlet vents are formed on the other side wall of the rack mount case 112 to be spaced a predetermined distance apart from the inlet vents 114. The two side walls may meet at an angle and may be perpendicular to each other. The opposite ends of the heat dissipation device 36 are positioned adjacent to the inlet vents 114 and the outlet vents, respectively. The positioning of the inlet vents 114 and the outlet vents allows ambient air to flow freely through the heat dissipation device 36 without interference from vertically adjacent cases of computers mounted on the same rack. As shown, a fan 116 is positioned adjacent to the outlet vents opposite to the inlet vents 114. Alternatively, the fan 116 itself may form outlet vents. A separating wall 118 is installed inside the case 112, and the separating wall 118 isolates components of the industrial computer 110 from the flow of ambient air passing through the heat dissipation device 36. Thus, even if the industrial computer 110 is used under inferior circumstances, external air is not induced to the components, thereby preventing the components from being contaminated due to foreign matter such as dust.

FIG. 20 is similar to FIG. 19 but shows a different type of rack mount industrial computer 110'. The computer 110' has a rack mount case 112'. In the industrial computer 110', inlet vents 114' and the fan 116 are located at opposite side walls of the case 112' rather than intersecting side walls shown in FIG. 19. Opposite separating walls 118' isolate components of the computer 110' from the flow of ambient air passing through the heat dissipation device 36. In FIGS. 19 and 20, radiating fins are preferably oriented horizontally, rather than vertically as in FIG. 4A. Arrows shown in FIGS. 19 and 20 indicate the directions of the flow of ambient air passing through the heat dissipation device 36.

As described above, according to the present invention, since heat-producing components are cooled by a liquid coolant circulating through a heat exchanging device installed to be securely in contact with the heat-producing components, the cooling capacity is enhanced compared to the conventional air cooling system. Also, since the flow of ambient air for cooling the warmed liquid coolant is isolated from the heat-producing components, internal contamination of a computer due to induction of dust can be prevented. Thus, the life span of a high-priced computer can be prolonged even under inferior circumstances and the defects thereof can be reduced. Also, in the case where the flow of ambient air is produced by natural convection, the noise due to use of a fan is not generated. In the case of using a fan, the fan is operated at a level of 70% rated power to prolong the life span of the fan and reduce the noise generated by the operation of the fan, thereby making agreeable working circumstances.

Although the preferred embodiments of the invention have been illustrated and described herein, it is intended to be understood by those skilled in the art that various modifications and omissions in form and detail may be made without departing from the spirit and scope of the invention as defined by the appended claims.

## Claims

1. A computer having a housing defining an interior space and at least one heat-producing component installed inside the housing, comprising:
a heat exchanging device in heat exchangeably contact with the heat-producing component and having a passageway extending between an inlet port and an outlet port;
a heat dissipation device having a reservoir for storing a liquid coolant having an inlet opening and an outlet opening spaced a predetermined distance apart from the inlet opening, and a plurality of radiating fins installed on the outer surface of the reservoir so as to be capable of exchanging heat with the reservoir;
a first conduit extending between the outlet port of the heat exchanging device and the inlet opening of the reservoir;
a second conduit extending between the outlet opening of the reservoir and the inlet port of the heat exchanging device;
a pump for pumping the liquid coolant out of the reservoir through the outlet opening, through the second conduit, the passageway and the first conduit, and back into the reservoir through the inlet opening; and
a separating wall separating the heat dissipation device from the interior space to isolate the heat-producing component from the flow of ambient air.

2. The computer according to claim 1, wherein the housing is a tower case, and includes a subhousing mounted on the bottom wall thereof, the heat dissipation device being mounted inside the subhousing, the subhousing having an inlet vent and an outlet vent formed adjacent to the opposite ends of the heat dissipation device.

3. The computer according to claim 1, wherein the housing is a tower case, and wherein the separating wall is installed inside the tower case to be spaced apart from one of the bottom wall and side wall of the tower case, the heat dissipation device is mounted between the separating wall and one of the bottom wall and the side walls of the tower case, and an inlet vent and an outlet vent are formed adjacent to the opposite ends of the heat dissipation device.

4. The computer according to claim 1, wherein the housing is a rack mounting case, and wherein an inlet vent and an outlet vent are formed at side walls of the case to be spaced apart from each other, and the opposite ends of the heat dissipation device are positioned adjacent to the inlet vent and the outlet vent.

5. The computer according to any one of claims 1 through 4, further comprising a fan disposed adjacent to one end of the heat dissipation device and in communication with ambient air, for compelling the ambient air to flow through the radiating fins to exhaust the heat from the liquid coolant stored in the reservoir, the fan being isolated from the interior space by the separating wall.

6. The computer according to claim 1, wherein at least one divider wall extending one-end inner wall of the reservoir and the end thereof is spaced from the opposite inner wall of the reservoir is installed inside the reservoir to elongate the path of the flow of the liquid coolant.

7. The computer according to claim 1, wherein the heat-producing component is a power supply having a plurality of heat-producing elements, wherein the heat exchanging device includes a heat sink on which the heat-producing elements are installed and which has a channel provided at each side thereof, and a U-shaped conduit fitted into the channel to be in heat exchangeably contact with the heat sink and having opposite ends forming the inlet port and the outlet port, and wherein the passageway of the heat exchanging device is formed by the U-shaped conduit.

8. The computer according to claim 1, wherein the heat-producing component is a power supply having a plurality of heat-producing elements, and wherein the heat exchanging device includes a heat sink on which the heat-producing elements are mounted and which has the passageway through which the liquid coolant passes, being formed inside the heat sink, and a conduit fitted into the opposite ends of the passageway forming the inlet port and the outlet port.

9. The computer according to claim 1, wherein the heat-producing component is a power supply having a plurality of heat-producing elements, wherein the heat exchanging device includes a hermetic container installed to surround the power supply and contains an insulating oil which is in direct contact with the power supply, and wherein the inlet port and the outlet port are formed at the side walls of the hermetic container and the insulating oil functions as the liquid coolant.

10. The computer according to claim 1, wherein the heat-producing component is a power supply having a plurality of heat-producing elements, wherein the heat exchanging device includes a hermetic container installed to surround the power supply and contains an insulating oil which is in direct contact with the power supply, a cooling plate being in heat exchangeably contact with the outer top surface of the hermetic container and having a U-shaped channel formed at one side being securely in contact with the hermetic container, and a U-shaped conduit fitted into the U-shaped channel, having a flat bottom so as to be securely in contact with the outer top surface of the hermetic container and having opposite ends forming the inlet port and the outlet port, and wherein the passageway of the heat exchanging device is formed by the U-shaped conduit.

11. The computer according to claim 1, wherein the heat-producing component is a hard drive, wherein the heat exchanging device includes a cooling plate being in heat exchangeably contact with the bottom surface of the hard drive and having a pair of channels spaced apart from each other on one surface being securely in contact with the hard drive, and a U-shaped conduit fitted into the pair of channels, having a flat top surface so as to be securely in contact with the bottom surface of the hard drive and having opposite ends forming the inlet port and the outlet port, and wherein the passageway of the heat exchanging device is formed by the U-shaped conduit.

12. The computer according to claim 1, wherein the heat-producing component is a swapping type hard drive replaceably mounted in a slot provided in the computer, wherein the heat exchanging device includes a heat collecting plate in heat exchangeably contact with the bottom surface of the hard drive, a cooling plate installed on the inner bottom of the slot, in heat exchangeably contact with the bottom surface of the heat collecting plate when the hard drive and the heat collecting plate are inserted into the slot and having a U-shaped channel on its bottom surface, a U-shaped conduit fitted into the U-shaped channel and having opposite ends forming the inlet port and the outlet port, and a plate spring having one end fixed installed on the slot, applying elasticity to the top surface of the hard drive to make the bottom surface of the heat collecting plate securely contact with the top surface of the cooling plate, and wherein the passageway of the heat exchanging device is formed by the U-shaped conduit.

13. The computer according to claim 1, wherein the heat-producing component is a central processing unit (CPU), and wherein the heat exchanging device includes a cooling plate having an inner surface on which the passageway is formed to be serpentine and an outer surface on which the inlet port and the outlet port protrude, and a bottom plate having one surface being in liquid tightly contact with the inner surface of the cooling plate and the other surface being in heat exchangeably contact with the surface of the CPU.

14. The computer according to claim 13, wherein a temperature sensor for controlling the temperature of the CPU is installed at one side of the cooling plate and the speed of the fan is adjusted according to the temperature detected by the temperature sensor and when the temperature exceeds a predetermined temperature, the system is configured to stop operating to issue a warning message.

15. The computer according to claim 13, wherein the CPU is a socket type CPU connected with a CPU socket having projections provided on at least two facing lateral sides, and wherein the heat exchanging device further includes a securely contacting means having a crossed compression plate installed on the cooling plate and having two facing ends bent downward, a thread hole formed in the center thereof and locking openings locked with the projections formed at the bent ends, and a fastening thread for securely contacting the bottom plate with the surface of the CPU by pressing the top surface of the cooling plate, and a thread center maintaining groove for maintaining the center of the fastening thread is provided in the center on the cooling plate.

16. The computer according to claim 13, wherein the CPU is a slot type CPU having an outer plate on which a plurality of first throughholes, the surface of the CPU being the outer surface of the outer plate, and wherein the heat exchanging device further includes a securely contacting means having a compression plate installed to be securely contact with the top surface of the cooling plate and having an opening formed in the central portion of the compression plate to allow the compression plate not to be interfered by the inlet port and the outlet port of the cooling plate, and a plurality of second throughholes corresponding to the first throughholes, formed at the edges thereof, and fasteners inserted into the first and second throughholes to allow the compression plate to press the top surface of the cooling plate to thus securely contact the bottom plate with the surface of the CPU.

17. The computer according to claim 1, wherein the heat-producing component is a memory, wherein the heat exchanging device includes a first cooling plate being in heat exchangeably contact with one side of the memory, a second cooling plate being in heat exchangeably contact with the other side of the memory, connecting projections provided on facing surfaces of the first and second cooling plates so as to be engaged with each other and having conduit insertion holes piercing lengthwise, a conduit having a long rod shape inserted through the conduit insertion holes in a state in which the first cooling plate and the second cooling plate are connected and having opposite ends forming the inlet port and the outlet port and a torsion spring interposed between the first cooling plate and the second cooling plate to apply elastic force such that the first and second cooling plates are brought securely into contact with both sides of the memory, and wherein the passageway of the heat exchanging device is formed by the rod-shaped conduit.

18. A heat exchanging device used for cooling a power supply having a plurality of heat-producing elements, comprising:
a heat sink on which the heat-producing elements are mounted and which has a channel provided at each side thereof; and
a U-shaped conduit fitted into the channel to be in heat exchangeably contact with the heat sink and having opposite ends forming an inlet port and an outlet port through which a liquid coolant for cooling the power supply, comes in and goes out,
wherein the liquid coolant circulates through a passageway formed by the U-shaped conduit.

19. A heat exchanging device used for cooling a power supply having a plurality of heat-producing elements, comprising:
a heat sink on which the heat-producing elements are mounted and which has a passageway through which a liquid coolant for cooling the power supply, passes, provided inside thereof; and
a conduit fitted into opposite ends of the passageway, forming an inlet port and an outlet port through which a liquid coolant for cooling the power supply, comes in and goes out,
wherein the liquid coolant circulates through the passageway.

20. A heat exchanging device used for cooling a power supply having a plurality of heat-producing elements, comprising:
a hermetic container installed to surround the power supply and contains an insulating oil which is in direct contact with the power supply; and
an inlet port and an outlet port formed at the side walls of the hermetic container so that the insulating oil comes in and goes out therethrough,
wherein the insulating oil functions as the liquid coolant for cooling the power supply.

21. A heat exchanging device used for cooling a power supply having a plurality of heat-producing elements, comprising:
a hermetic container installed to surround the power supply and contains an insulating oil which is in direct contact with the power supply;
a cooling plate being in heat exchangeably contact with the outer top surface of the hermetic container and having a U-shaped channel formed at one side being securely in contact with the hermetic container; and
a U-shaped conduit fitted into the U-shaped channel, having a flat bottom so as to be securely in contact with the outer top surface of the hermetic container and having opposite ends forming an inlet port and an outlet port,
wherein the liquid coolant circulates by a passageway formed by the U-shaped conduit.

22. A heat exchanging device used for cooling a hard drive of a computer, comprising:
a cooling plate being in heat exchangeably contact with the bottom surface of the hard drive and having a pair of channels spaced apart from one side being securely in contact with the hard drive; and
a U-shaped conduit fitted into the pair of channels, having a flat top surface so as to be securely in contact with the bottom surface of the hard drive and having opposite ends forming the inlet port and the outlet port,
wherein the liquid coolant circulates by the passageway formed by the U-shaped conduit.

23. A heat exchanging device used for cooling a swapping type hard drive replaceably mounted in a slot provided in the computer, comprising:
a heat collecting plate in heat exchangeably contact with the bottom surface of the hard drive so as to be capable of exchange heat;
a cooling plate installed on the inner bottom of the slot, in heat exchangeably contact with the bottom surface of the heat collecting plate when the hard drive and the heat collecting plate are inserted into the slot and having a U-shaped channel on its bottom surface;
a U-shaped conduit fitted into the U-shaped channel and having opposite ends forming an inlet port and an outlet port; and
a plate spring having one end fixed installed on the slot, applying elasticity to the top surface of the hard drive to make the bottom surface of the heat collecting plate securely contact with the top surface of the cooling plate,
wherein the liquid coolant circulates by a passageway formed by the U-shaped conduit.

24. A heat exchanging device used for cooling a central processing unit (CPU) of a computer, comprising:
a cooling plate having an inner surface on which a passageway is formed to be serpentine and an outer surface on which an inlet port and an outlet port protrude; and
a bottom plate having one surface being in liquid tightly contact with the inner surface of the cooling plate and the other surface being in heat exchangeably contact with the surface of the CPU,
wherein the liquid coolant circulates by the passageway.

25. The heat exchanging device according to claim 24, wherein the CPU is a socket type CPU connected with a CPU socket having projections provided on at least two facing lateral sides, further comprising:
a securely contacting means having a crossed compression plate installed on the cooling plate and having two facing ends bent downward, a thread hole formed in the center thereof and locking openings locked with the projections formed at the bent ends, and a fastening thread for securely contacting the bottom plate with the surface of the CPU by pressing the top surface of the cooling plate,
wherein a thread center maintaining groove for maintaining the center of the fastening thread is provided in the center on the cooling plate.

26. The heat exchanging device according to claim 25, wherein rotation preventing grooves are vertically formed on at least one of four lateral surfaces of the cooling plate and rotation preventing ribs protrude downward from the compression plate to be disposed at locations corresponding to the rotation preventing grooves so as to be fitted into the rotation preventing grooves, so that the heat exchanging device is prevented from rotating when the fastening thread is fastened.

27. The heat exchanging device according to claim 24, wherein the CPU is a slot type CPU having an outer plate on which a plurality of first throughholes, the surface of the CPU being the outer surface of the outer plate, and the heat exchanging device further including a securely contacting means having a compression plate installed to be securely contact with the top surface of the cooling plate and having an opening formed in the central portion of the compression plate to allow the compression plate not to be interfered by the inlet port and the outlet port of the cooling plate, and a plurality of second throughholes corresponding to the first throughholes, formed at the edges thereof, and fasteners inserted into the first and second throughholes to allow the compression plate to press the top surface of the cooling plate to thus securely contact the bottom plate with the surface of the CPU.

28. A heat exchanging device used for cooling a memory of a computer, comprising:
a first cooling plate being in heat exchangeably contact with one side of the memory;
a second cooling plate being in heat exchangeably contact with the other side of the memory;
connecting projections provided on facing surfaces of the first and second cooling plates so as to be engaged with each other and having conduit insertion holes piercing lengthwise;
a conduit having a long rod shape inserted through the conduit insertion holes in a state in which the first cooling plate and the second cooling plate are connected and having opposite ends forming an inlet port and an outlet port; and
a torsion spring interposed between the first cooling plate and the second cooling plate to apply elastic force such that the first and second cooling plates are brought securely into contact with both sides of the memory,
wherein liquid coolant circulates by a passageway formed by the rod-shaped conduit.
